Europäisches Patentamt

European Patent Office

Office européen des brevets

(11) Publication number: **0 355 466**
**A2**

## EUROPEAN PATENT APPLICATION

(21) Application number: 89113871.1

(22) Date of filing: 27.07.89

(51) Int. Cl.4 **G06F 1/04**

(30) Priority: 26.08.88 US 237022

(43) Date of publication of application:
28.02.90 Bulletin 90/09

(84) Designated Contracting States:
**DE FR GB IT**

(71) Applicant: MOTOROLA, INC.
1303 East Algonquin Road
Schaumburg Illinois 60196(US)

(72) Inventor: McDermott, Mark W.
8905 Rockcrest Drive
Austin Texas 78759(US)
Inventor: Fourcroy, Antone L.
11631 Quarterhorse Trail
Austin Texas 78750(US)

(74) Representative: Holt, Michael et al
MOTOROLA European Intellectual Property
Operations Jays Close, Viables Ind. Est.
Basingstoke Hants, RG22 4PD(GB)

(54) Integrated circuit with clock generator circuit.

(57) A microprocessor (10) or other integrated circuit including a clock generator circuit which is dependent on an externally-provided reference signal (XTALCLK) includes the capability of detecting the loss of this externally-provided reference signal and producing an alternate clock signal despite the loss of the reference. In a particular embodiment, the clock generator comprises a phase locked loop frequency synthesizer (23-27) which normally relies on an external crystal oscillator for its reference frequency signal. The generator includes a circuit (22) for detecting abnormalities in the crystal signal and switching the voltage controlled oscillator of the frequency synthesizer to an internally-generated reference voltage. In the particular embodiment, the clock generator is also capable of producing a reset signal in response to the loss of the reference signal.

## INTEGRATED CIRCUIT WITH CLOCK GENERATOR CIRCUIT

### Field of the Invention

The present invention relates, in general, to a microprocessor or other integrated circuit device with an on-board clock signal generating circuit. More particularly, the invention relates to a clock signal generating circuit which normally relies on an external crystal oscillator to provide the reference frequency from which the clock signal is generated, but which is capable of detecting the loss of the reference frequency and reverting to a "limp mode" in which a stable clock signal is produced without an external reference frequency.

### Background of the Invention

Microprocessors and other integrated circuits typically require stable clock signals for their internal operations. In very early integrated circuit microprocessors, these signals are provided by circuits external to the microprocessor, typically in the form of a second integrated circuit dedicated to that purpose. In more recent designs, the clock signal generating circuits are integrated onto the same chip as the microprocessor or other device. In either case, the clock signal generating circuits typically rely upon an externally-provided crystal oscillator to provide the reference frequency upon which the clock signal is based.

The generation of a stable, known duty-cycle clock signal from the signal provided by the external crystal oscillator is accomplished by any of several known means. Most commonly, an inverter circuit of the general type disclosed in U.S. Patent 3,676,801 is used in conjunction with the crystal to produce an acceptable clock signal. This clock signal may be divided down to the desired frequency of the clock signal for the microprocessor or other circuit. In some cases, a phase locked loop (PLL) frequency synthesizer circuit is used in addition to the basic input circuit. The PLL circuit typically comprises a phase comparator, a filter, a voltage controlled oscillator (VCO) and a divider chain. An example of a microprocessor with such a clock signal generating circuit is the MC146805H2, which is available from Motorola, Inc. of Austin, Texas.

A problem which occurs in integrated circuits which rely upon an external crystal oscillator as a clock signal reference, and particularly in microprocessors, is that of loss of the crystal signal. Through mechanical failure or other causes, the frequency reference signal produced by the crystal oscillator may be lost. This causes the microprocessor to stop operating suddenly. For instance, if the microprocessor is performing engine control functions in a vehicle, the engine may stop suddenly and, perhaps, place the occupants of the vehicle in some danger. Problems such as loss of the crystal reference signal become more important as microprocessors are increasingly used in harsh environments, such as that of an under-hood engine management system.

### Summary of the Invention

Accordingly, it is an object of the present invention to provide an improved clock signal generating circuit for use in an integrated circuit.

These and other objects and advantages of the present invention are provided by an integrated circuit comprising clock signal generator means for receiving a reference signal and for generating a clock signal of a first frequency, the generator means further comprising: first means for detecting the absence of the reference signal and for producing a loss of signal output; and second means coupled to the loss of signal output of the first means for generating a clock signal of a second frequency different from the first frequency in response to receipt of the loss of signal output for the first means.

These and other objects and advantages will be apparent to one of skill in the art from the detailed description below taken together with the drawings.

### Brief Description of the Drawings

FIG. 1 is a block diagram of an integrated circuit microcomputer of a particular embodiment of the present invention;

FIG. 2 is a block diagram of the clock signal generator apparatus of the microcomputer of FIG. 1;

FIG. 3 is a diagram illustrating the bits of a control register of the apparatus of FIGs. 1 and 2; and

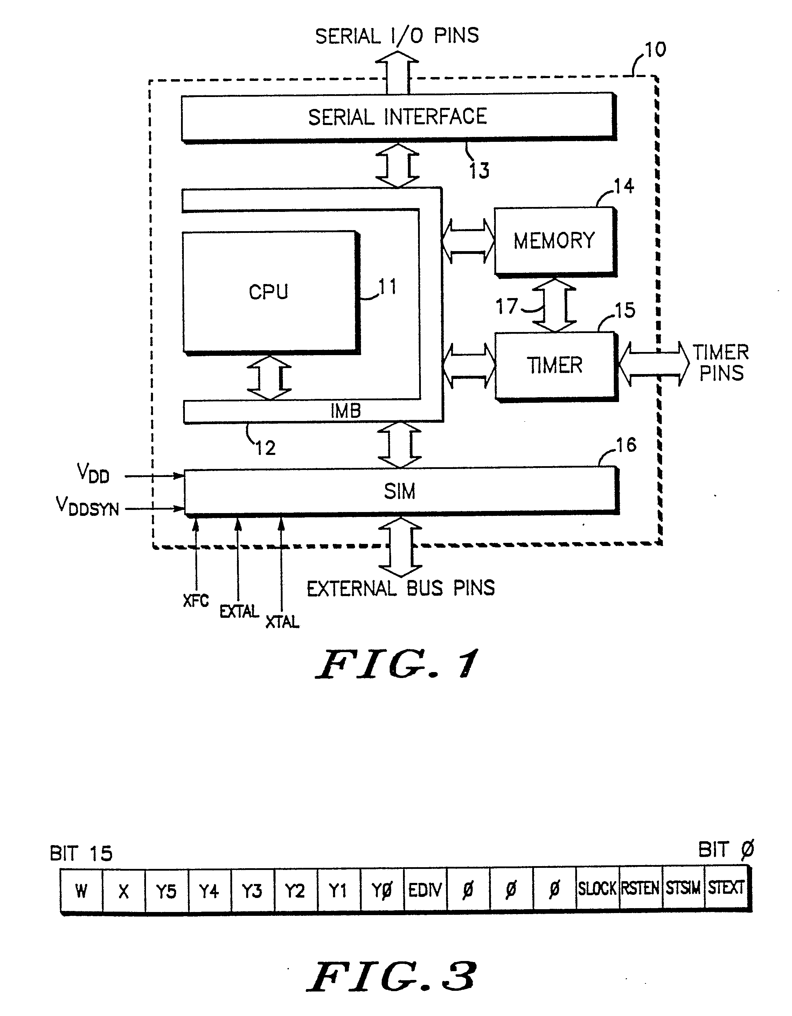

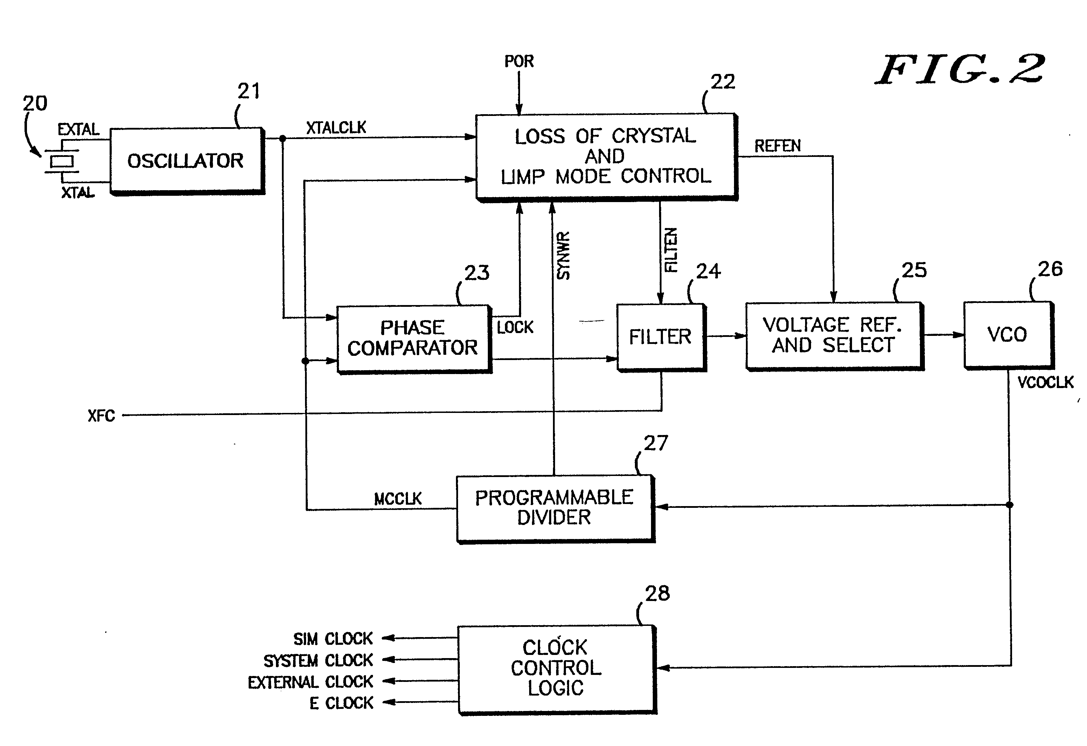

FIG.s 4A-4C are a logic diagram of a loss of crystal detect and limp mode control logic portion of the apparatus of FIGs. 1 and 2.

### Detailed Description of the Invention

The terms "assert" and "negate", and various grammatical forms thereof, are used herein to avoid confusion when dealing with a mixture of "active high" and "active low" logic signals. "Assert" is used to refer to the rendering of a logic signal or register bit into its active, or logically true, state. "Negate" is used to refer to the rendering of a logic signal or register bit into its inactive, or logically false state.

FIG. 1 illustrates a microcomputer of which a preferred embodiment of the present invention is a part. Microcomputer 10, which is intended for manufacture as a single integrated circuit, comprises a central processing unit (CPU) 11, an inter-module bus (IMB) 12, a serial interface 13, a memory module 14, a timer 15 and a system integration module (SIM) 16. Each of CPU 11, serial interface 13, memory 14, timer 15 and SIM 16 is bi-directionally coupled to IMB 12 for the purpose of exchanging address, data and control information. In addition, timer 15 is bi-directionally coupled to memory 14 by means of an emulation bus 17.

Serial interface 13 and timer 15 are each coupled to a number of pins, or connectors, for communication with devices external to microcomputer 10. In addition, SIM 16 is coupled to a number of pins comprising an external bus and to power supply ($V_{DD}$ and $V_{DDSYN}$) and crystal oscillator (EXTAL, XTAL and XFC) pins.

SIM 16 includes many of the features necessary for implementing a modular microcomputer architecture. In addition to many other functions, SIM 16 is responsible for generating the clock signals relied upon by all of the other components of microcomputer 10 and those external devices coupled to the external bus. A crystal may be connected across the EXTAL and XTAL pins and used to generate a reference frequency signal which is used by circuits internal to SIM 16 to generate the necessary clock signals. In addition, an externally generated clock signal may be directly provided to the EXTAL pin, obviating the need for the internal clock generating circuits. This is a common feature of integrated circuits with clock generating circuits. The $V_{DDSYN}$ input is used to provide a separate power supply for the clock generating circuit, in order to reduce noise and interference problems. The XFC pin is used to connect an external filter capacitor into the clock generating circuit, as is disclosed more fully below.

FIG. 2 is a block diagram of the clock generating apparatus of the microcomputer of FIG. 1. This circuit, as mentioned, is located within SIM 16. The basic components of this apparatus include an oscillator circuit 21, loss of crystal and limp mode control logic 22, a phase comparator 23, a loop filter 24, voltage reference and select logic 25, a voltage-controlled oscillator 26, a programmable divider 27 and clock control logic 28.

A crystal 20 is connected across the EXTAL and XTAL pins, which are connected to an oscillator circuit 21. The output of oscillator circuit 21 is a signal XTALCLK. The XTALCLK signal is connected as an input to loss of crystal and limp mode control logic circuit 22 and to phase comparator circuit 23. Logic 22 also receives inputs signal POR (power-on reset), LOCK (synthesizer lock), MCCLK and SYNWR (synthesizer write) and produces output signals FILTEN (filter enable) and REFEN (reference voltage enable). Phase comparator 23 receives the XTALCLK and MCCLK signals as inputs and produces the LOCK signal and a phase error signal as outputs. Loop filter circuit 24 receives the phase error output of phase comparator 23 and the FILTEN signal from logic 22 as inputs and produces a control voltage signal as an output. In addition, filter circuit 24 is connected to the XFC pin to allow an external filter capacitor to be connected to filter circuit 24. The control voltage output of filter circuit 24 is connected to an input of voltage reference and select logic circuit 25. Circuit 25 also receives the REFEN signal produced by logic 22 as an input. The output of circuit 25 is connected to the input of VCO 26. The output of VCO 26 is a clock signal VCOCLK. This clock signal is provided as an input to programmable divider 27, which produces the MCCLK signal, and to clock control logic 28, which produces the various clock signals used by microcomputer 10.

But for the operation of loss of crystal and limp mode control logic 22 and voltage reference and select logic 25, the apparatus of FIG. 2 operates in the familiar manner as a PLL frequency synthesizer and clock generator. The loop circuit comprising phase comparator 23, loop filter 24, VCO 26 and programmable divider 27 receives the oscillator signal XTALCLK as a frequency reference signal and produces a synthesized signal VCOCLK, the frequency of which is related to that of XTALCLK by the operation of programmable divider 27. The clock generator portion of the apparatus, comprising clock control logic 28, simply takes the VCOCLK signal and produces several different clock signals therefrom. The SIM clock signal is used to supply SIM 16 with its clocking signals. The system clock signal is used by most of the remainder of microcomputer 10 and is one of the signals carried by IMB 12. The external clock is one of the signals carried by the external bus and is used by devices external to microcomputer 10. The E clock is used by a portion of SIM 16 which generates chip selects signals for use by devices external to microcomputer 10 and is provided mainly to maintain compatibility with previously-designed peripheral components. The design, manufacture and operation of PLL frequency synthesizers and clock generator circuits is well known in the semiconductor industry and will not be further described herein.

Whenever logic 22 detects the loss of the crystal reference signal or the occurrence of other events described below, the REFEN signal is asserted. This causes logic 25 to disconnect the output of loop filter 24 from the input of VCO 26 and substitute the output of a voltage reference circuit. Thus, the operation of VCO 26 is no longer dependent on the control voltage signal produced by loop filter 24 to determine its operating frequency. Instead, the operating frequency of VCO 26 is determined solely by the chosen output voltage of the voltage reference circuit. The reference voltage will usually, but not necessarily, be chosen to provide a much lower frequency VCOCLK than is provided in normal operation. The purpose is not to maintain system operation as if the crystal signal had not been lost, but to provide a fall-back mode of operation in which microcomputer 10 can either perform an orderly shutdown or continue to operate at a much-reduced level of capacity.

The design details of logic 25 will be immediately apparent to one of skill in the art. Many suitable voltage reference circuits are widely known. A voltage reference suitable for this application should have a relatively stable output over the specified temperature range of microcomputer 10 and should also be relatively stable over variations in the process used to manufacture the integrated circuit. The voltage select portion of circuit 25 perform a simple single-pole, double-throw switching function to select, under the control of the REFEN signal, which of the two available control voltages to apply to the input of VCO 26.

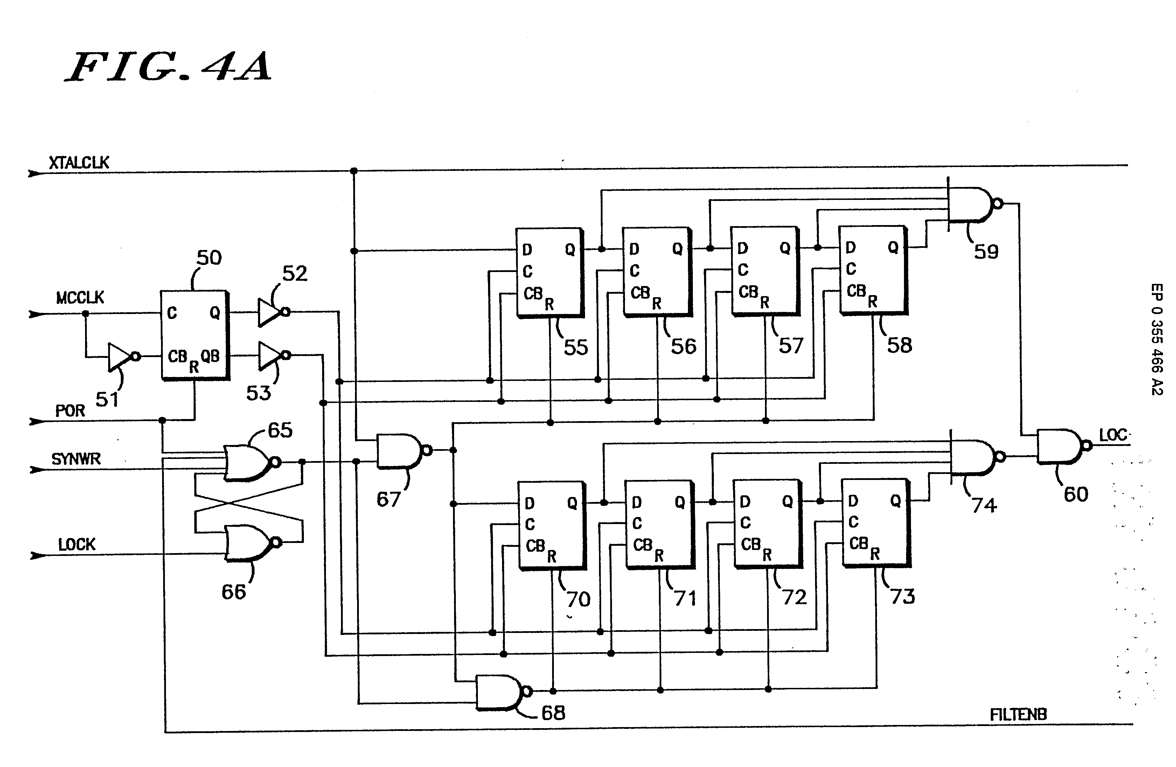

FIG. 3 illustrates a 16-bit synthesizer control register used by the apparatus of FIG. 2. This register is readable and writable by CPU 11. The upper byte (bits 8-15) of this register control the frequency of operation of the clock signal generating apparatus. Bits 8-13 (Y0-Y5) and bit 15 (W) control programmable divider 27. Bit 14 (X) controls a prescaler in clock control logic 28. In the particular embodiment, the frequency of VCOCLK is given by $F = F_{EXTAL} \cdot 4(Y + 1)(2^{2W})$. Adding the effect of the X bit prescaler in logic 28, the system clock frequency is given by $F = F_{EXTAL} \cdot 4(Y + 1) \cdot (2^{2W + X})$. As is apparent, any change in programmable divider 27 will result in a temporary loss of "lock" by the synthesizer. The provision of the X bit pre-scaler in logic 28 allows the frequency of the clock signals produced by logic 28 to be changed quickly (although only by a factor of two) without upsetting the synthesizer circuit.

Bit 7 (EDIV) is used to determine the divide ratio between the E clock and external clock signals generated by logic 28. If EDIV is 1, the external clock is divided by 16 to produce the E clock. If EDIV is 0, the external clock is divided by 8.

Bits 4-6 of this register are not used and read as zero.

Bit 3 (SLOCK) of this register is a read-only status flag which, when equal to 1, indicates that either the internal clock generation apparatus is disabled, or that the PLL is locked onto the desired frequency of operation. If equal to 0, the clock generation apparatus is enabled and not yet locked onto a stable frequency.

Bit 2 (RSTEN) determines which of two options are executed in response to a loss of crystal detection. If equal to 1, SIM 16 will cause a system reset upon loss of crystal. If equal to 0, loss of crystal will cause the limp mode to be entered, in which the clock signal continues to be generated, but at a much-reduced frequency.

Bit 1 (STEXT) determines the effect on the external clock signal when CPU 11 executes a low power stop instruction. If 1, logic 28 will continue to drive the external clock signal from the SIM clock signal during the power-down period following the instruction. If 0, the external clock line is driven low during power-down.

Bit 0 (STSIM) determines the effect on the SIM clock when CPU 11 executes the low power stop instruction. If 1, the clock generating apparatus continues to operate normally to generate the SIM clock from VCOCLK during the low power period. If 0, the SIM clock is driven directly by EXTALCLK during the low power period and the frequency synthesizer is shut down to reduce power consumption. Since the SIM contains the interrupt and reset circuits which are capable of ending the power-down period, some clock signal must be provided to the SIM during the power-down period.

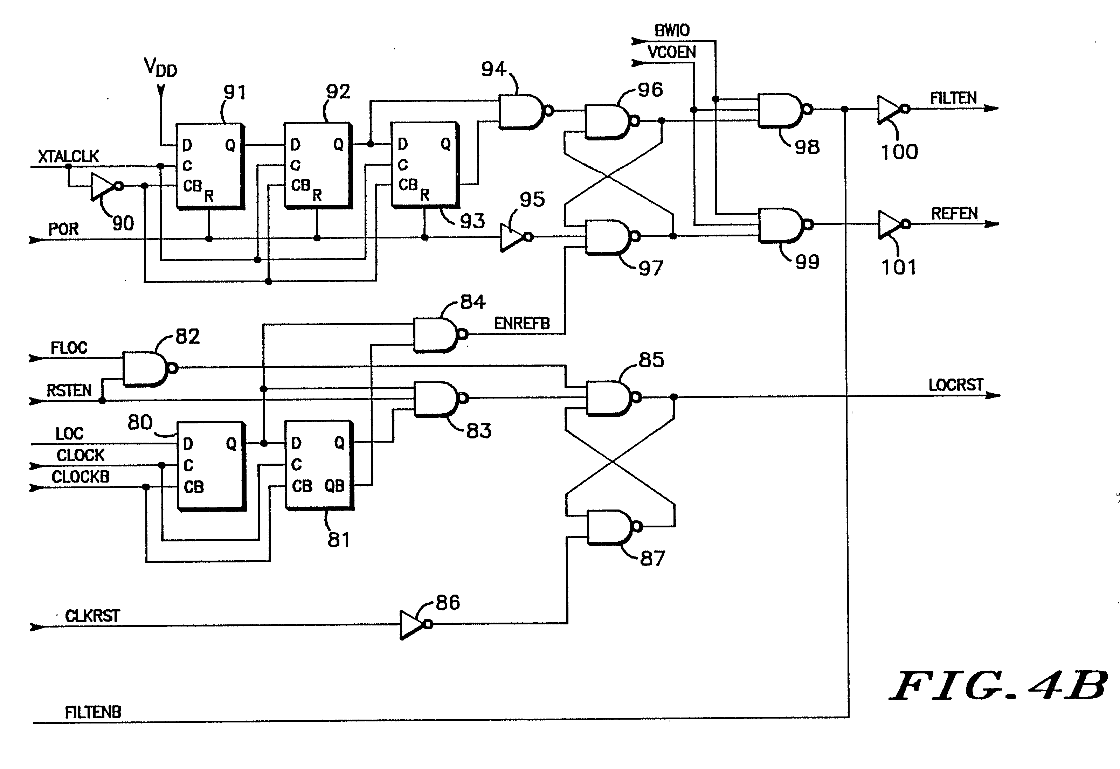

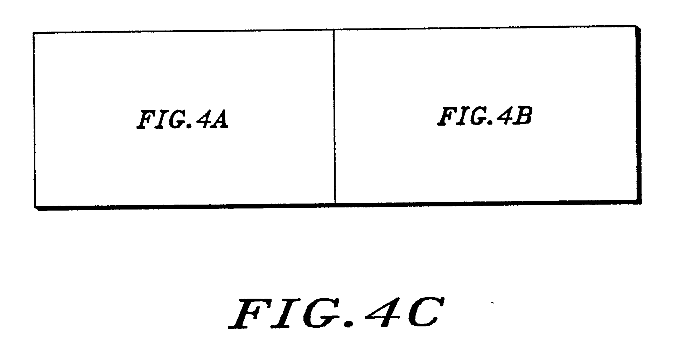

FIG.s 4A and 4B comprise a logic diagram of loss of crystal and limp mode control logic 22 of FIG. 2. FIG. 4C illustrates how FIG.s 4A and 4B inter-relate. The apparatus of FIG. 4A performs the loss of crystal detection function and the apparatus of FIG. 4B performs the function of generating control signals therefrom.

The apparatus of FIG. 4A operates, in summary, by using the MCCLK signal to clock two four-stage shift registers. One of the shift registers is used to detect when the XTALCLK signal remains in a high state for too long and the other shift register is used to detect when the XTALCLK signal remains in a low state for too long. When either case is true an LOC (loss of crystal) signal is asserted.

The four signals which comprise the inputs of the apparatus of FIG. 4A are XTALCLK, MCCLK, POR, SYNWR and LOCK. The SYNWR signal indicates that the settings of programmable divider 27 have been changed by a write to the synthesizer control register. The other signals have been described above. The MCCLK signal is connected to the clock (C) input of a flip-flop 50 and, through an inverter 51, to the clock-bar (CB) input of flip-flop 50. The POR signal is connected to the reset (R) input of flip-flop 50. The Q output of flip-flop 50 is connected to the input of an inverter 52 and the QB output of flip-flop 50 is connected to the input of an inverter 53. The outputs of inverters 52 and 53 provide the clock signals which drive the two shift registers described above.

The "stuck high" shifter register comprises latches 55, 56, 57 and 58. The C input of each is connected to the output of inverter 52 and the CB input of each is connected to the output of inverter 53. The D input of latch 55 is connected to the XTALCLK signal and the D inputs of each of the succeeding latches is connected to the Q output of the preceding latch. The Q outputs of all of the latches 55-58 are connected as inputs to a NAND gate 59, whose output is connected as an input to a NAND gate 60. The output of NAND gate 60 is the LOC signal.

The SYNWR signal is connected as an input of an NOR gate 65. The POR signal is connected as another input of NOR gate 65, as is the inverse of the FILTEN signal, FILTENB. The fourth input of NOR gate is the output of an NOR gate 66. The LOCK signal is connected as one input of NOR gate 66 and the output of NOR gate 65 is the other input of NOR gate 66. The output of NOR gate 65 is connected as one input of a NAND gate 67 and as one input of a NAND gate 68. The XTALCLK signal is connected as an input of NAND gate 67. The output of NOR gate 65 is connected as an input of NAND gate 68.

The output of NAND gate 67 is connected to the reset inputs of each of latches 55-58. Under normal operating conditions, each time XTALCLK goes low, the output of NAND gate 67 goes high, which resets latches 55-58. If, however, XTALCLK stays high for a sufficiently long period, this high value will be clocked through all of latches 55-88 and all of the inputs to NAND gate 59 will become active, resulting in the assertion of LOC.

The "stuck low" shift register comprises latches 70, 71, 72 and 73. The C and CB inputs of each are connected to the outputs of inverters 52 and 53, respectively. The D input of latch 70 is connected to the output of NAND gate 67 and the D inputs of each of the succeeding latches is connected to the Q output of the preceding stage. The Q outputs of each of latches 70-73 are connected as inputs to a NAND gate 74. The output of NAND gate 74 is connected as an input of NAND gate 60.

The reset inputs of each of latches 70-73 are connected to the output of NAND gate 68. Under normal operating conditions, each time XTALCLK goes high, the output of NAND gate 68 goes high, which resets latches 70-73. If, however, XTALCLK stays low for a sufficiently long period, the high value at the output of NAND gate 67 will be clocked through all of latches 70-73 and all of the inputs to NAND gate 74 will become active, resulting in the assertion of LOC.

As described, the apparatus of FIG. 4A will assert the LOC signal whenever the XTALCLK signal has been stuck in a particular state for more than a predetermined length of time. Under certain conditions, the most important of which is a change in the divide ratio of programmable divider 27 (FIG. 2), it is desirable to prevent the assertion of LOC.

Consider a change in the divide ratio which is intended to result in a slower system clock (i.e.: a decrease in the value of the Y or W bits of the synthesizer control register). The immediate effect of such a change is that MCCLK will be at a much higher frequency than XTALCLK, at least until the phase-locked loop re-establishes stable operation. If some precaution were not taken against this situation, this might result in the inadvertent assertion of LOC, since MCCLK controls the rate at which the "stuck high" and "stuck low" shift registers are clocked. This result is undesirable because VCO 26 (FIG. 2) would slew toward the operating frequency determined by the voltage reference circuit rather than that determined by the new synthesizer control register setting.

The function of preventing the assertion of LOC under these circumstances is served by NOR gates 65 and 66. Under normal operating conditions, LOCK is active and POR, SYNWR and FILTENB are inactive. Thus, the output of NOR gate 65 is active. This enables the outputs of NAND gates 67 and 68 to change with the changes of XTALCLK. However, when SYNWR is asserted, reflecting a change in the synthesizer control register, the output of NOR gate 65 becomes inactive, forcing the outputs of NAND gates 67 and 68 to remain active regardless of XTALCLK. This keeps both the "stuck high" and the "stuck low" shift registers in reset and prevents the assertion of LOC. Because of the cross-coupling of NOR gates 65 and 66, the output of NOR gate 65 remains inactive until LOCK has become inactive and been re-asserted by the establishment of stable operation at the new operating frequency.

The apparatus of FIG. 4B performs the functions required to generate the FILTEN and REFEN control signals, in addition to generating a loss of crystal reset signal (LOCRST) in appropriate circumstances. The input signals to the illustrated apparatus include XTALCLK, POR and the LOC signal produced by the apparatus of FIG. 4A. In addition, signals referred to as FLOC (force loss of crystal), RSTEN (loss of crystal reset enable) and CLKRST (clock reset) provide inputs. A clock signal (CLOCK and CLOCKB) which is related to the SIM Clock signal produced by logic 28 of FIG. 1 is also used. The FLOC signal is a test signal which forces a loss of crystal reset condition. The RSTEN signal is related to bit 2 of the synthesizer control register. The CLKRST signal is a clock reset signal.

The LOC signal is connected to the D input of a latch 80, the C and CB inputs of which are connected to the CLOCK and CLOCKB signals, respectively. The Q output of latch 80 is connected to the D input of a latch 81, which is also clocked by the CLOCK and CLOCKB signals. The RSTEN and FLOC signals are connected as inputs to a NAND gate 82. The RSTEN signal is also connected as an input to a NAND gate 83. The Q output of latches 80 and 81 are also connected as inputs to NAND gate 83. The QB output of latch 81 is connected as an input to a NAND gate 84. The Q output of latch 80 is also connected as an input of NAND gate 84. The output of NAND gate 84 is a signal referred to as ENREFB. The output of NAND gate 82 is connected as an input of a NAND gate 85. The output of NAND gate 83 is also connected as an input of NAND gate 85. The CLKRST signal is connected as the input of an inverter 86. The output of inverter 86 is connected as an input of a NAND gate 87. The output of NAND gate 85 is also connected as an input of NAND gate 87. The output of NAND gate 87 is connected as an input of NAND gate 85. The output of NAND gate 85 is the LOCRST signal which causes microcomputer 10 to be reset upon loss of crystal, if the appropriate logical conditions are met.

The XTALCLK signal is connected to the input of an inverter 90. The C and CB inputs of a shift register comprising latches 91, 92 and 93 are connected to the XTALCLK signal and the output of inverter 90, respectively. The D input of latch 91 is connected to $V_{DD}$. The Q output of latch 91 is connected to the D input of latch 92 and the Q output of latch 92 is connected to the D input of latch 93. The Q output of latch 92 and the QB output of latch 93 are connected as inputs of a NAND gate 94. The POR signal is connected to the reset inputs of latches 91, 92 and 93. The POR signal is also connected to the input of an inverter 95. The output of NAND gate 94 is connected as an input of a NAND gate 96. The output of NAND gate 96 is connected as an input of a NAND gate 97. The output of inverter 95 and the ENREFB signal are connected as inputs of NAND gate 97. The output of NAND gate 97 is connected as an input of NAND gate 96. The output of NAND gate 96 is connected as an input of NAND gate 98. A test signal referred to as $BW_{10}$ and a signal referred to as VCOEN (VCO enable) are also connected as inputs of NAND gate 98. The BW10 and VCOEN signals are also connected as input of a NAND gate 99. The output of NAND gate 97 is also connected as an input of NAND gate 99. The output of NAND gate 98 is the FILTENB signal and is connected to the input of an inverter 100. The output of inverter 100 is the FILTEN signal. The output of NAND gate 99 is connected as the input of an inverter 101. The output of inverter 101 is the REFEN signal.

While the apparatus if FIG.s 4A and 4B perform the necessary loss of crystal detection and control signal generation functions in the particular embodiment of the invention being described here, many possible alternative logic designs exist which would perform the same functions. The apparatus described requires that the EXTALCLK signal remain in the same state for a predetermined length of time before the LOC signal is generated, thus ensuring that momentary losses of the crystal reference signal do not cause limp mode entry. Further, the disclosed apparatus uses the reference voltage to drive the VCO, rather than the crystal reference, during power-on reset. This is intended to provide faster stabilization of the VCOCLK signal after a power-on reset, since the VCO frequency will slew more rapidly toward its eventual stable operating point if driven by the more stable reference voltage.

The disclosed apparatus provides an improved clock generating circuit for a microprocessor or other integrated circuit. Upon loss of the reference signal from the crystal, the disclosed apparatus produces a stable, although usually slower, clock signal. Alternatively, the apparatus is programmable to produce a reset upon detection of loss of crystal. Either mode of operation provides a predictable response to loss of the crystal signal, as opposed to the unpredictable results produced by prior art clock signal generating circuits. It is possible that, in some circumstances, the alternate clock signal produced while in the limp mode will actually be faster than the normal clock signal. This is due to the fact that the limp mode clock rate is established by the reference voltage circuit and, in the particular embodiment described, is approximately 8 MHz, while the normal clock signal is programmable by means of the various bits of the control register illustrated in FIG. 3 from approximately 0.1 MHz to approximately 65 MHz (assuming a crystal frequency of approximately 32kHz).

While the present invention has been shown and described with reference to a particular embodiment thereof, various modifications and changes thereto will be apparent to those skilled in the art and are within the spirit and scope of the

## Claims

1. An integrated circuit comprising:
clock signal generator means (22-28) for receiving a reference frequency signal and for generating a clock signal of a first predetermined frequency in response to the reference frequency signal;
wherein the improvement comprises:
loss of reference signal detect means (22) for receiving the reference frequency signal and for producing a loss of reference output signal in response to a predetermined condition of the reference frequency signal; and
the clock signal generator means being responsive to the loss of reference output of the loss of reference signal detect means for generating a clock signal of a second frequency different from the first predetermined frequency.

2. An integrated circuit according to claim 1 wherein the loss of reference signal detect means further comprises:
first means (55-59) for detecting the occurrence of a period of predetermined length during which the reference frequency signal remains in a first predetermined state; and
second means (70-74) for detecting the occurrence of a period of predetermined length during which the reference frequency signal remains in a second predetermined state; and
third means (60) for producing the loss of reference output signal in response to either of said first and second means.

3. An integrated circuit according to claim 1 wherein the clock signal generator further comprises:
an oscillator circuit (21) coupled to a crystal oscillator external to the integrated circuit, an output of the oscillator comprising the reference frequency signal;
a phase locked loop frequency synthesizer (23, 24, 25, 26, 27) comprising an input coupled to the output of the oscillator circuit, an output of the phase locked loop frequency synthesizer comprising a clock signal having a frequency related to the frequency of the reference frequency signal, the phase locked loop frequency synthesizer further comprising an input coupled to an output of the loss of reference signal detect means and being capable of generating a clock signal having a frequency unrelated to the frequency of the reference frequency signal in response to the signal received therefrom.

4 An integrated circuit according to claim 3 further comprising:
reset means (83, 85, 87) for receiving the loss of reference output signal from the loss of reference signal detect means and for selectably producing a reset signal in response thereto; and
control means (RSTEN) for controlling whether the reset means generates the reset signal in response to the loss of reference output signal.

5. An integrated circuit according to claim 3 wherein:
the phase locked loop frequency synthesizer further comprises a programmable divider (27); and
the loss of reference frequency detect means is responsive to the programming of the programmable divider to produce an output signal.

6. A microprocessor (10) comprising clock signal generator means (22-28) for receiving a reference frequency signal and for generating a clock signal of a first predetermined frequency in response to the reference frequency signal, the clock signal generator means further comprising:
loss of reference signal detect means (22) for receiving the reference frequency signal and for producing a loss of reference output signal in response to a predetermined condition of the reference frequency signal; and
the clock signal generator means being responsive to the loss of reference output of the loss of reference signal detect means for generating a clock signal of a second frequency different from the first predetermined frequency.

7. A microprocessor according to claim 6 wherein the loss of reference signal detect means further comprises:
first means (55-59) for detecting the occurrence of a period of predetermined length during which the reference frequency signal remains in a first predetermined state; and
second means (70-74) for detecting the occurrence of a period of predetermined length during which the reference frequency signal remains in a second predetermined state; and
third means (60) for producing the loss of reference output signal in response to either of said first and second means.

8. A microprocessor according to claim 6 wherein the clock signal generator further comprises:
an oscillator circuit (21) coupled to a crystal oscillator external to the integrated circuit, an output of the oscillator comprising the reference frequency signal;
a phase locked loop frequency synthesizer (23, 24, 25, 26, 27) comprising an input coupled to the output of the oscillator circuit, an output of the phase locked loop frequency synthesizer comprising a clock signal having a frequency related to the frequency of the reference frequency signal, the phase locked loop frequency synthesizer further comprising an input coupled to an output of the loss of reference signal detect means and being capable of generating a clock signal having a frequency unrelated to the frequency of the reference frequency signal in response to the signal received therefrom.

9. A microprocessor according to claim 8 further comprising:

reset means (83, 85, 87) for receiving the loss of reference output signal from the loss of reference signal detect means and for selectably producing a reset signal in response thereto; and

control means (RSTEN)for controlling whether the reset means generates the reset signal in response to the loss of reference output signal.

10. A microprocessor according to claim 8 wherein:

the phase locked loop frequency synthesizer further comprises a programmable divider (27); and

the loss of reference frequency detect means is responsive to the programming of the programmable divider to produce an output signal.

SERIAL I/O PINS

SERIAL INTERFACE

13

MEMORY 14

CPU 11

IMB

12

17

TIMER 15

TIMER PINS

$V_{DD}$

$V_{DDSYN}$

SIM 16

EXTERNAL BUS PINS

XFC EXTAL XTAL

10

*FIG. 1*

BIT 15

| W | X | Y5 | Y4 | Y3 | Y2 | Y1 | YØ | EDIV | Ø | Ø | Ø | SLOCK | RSTEN | STSIM | STEXT |
|---|---|----|----|----|----|----|----|------|---|---|---|-------|-------|-------|-------|

BIT Ø

*FIG. 3*

*FIG.2*

*FIG. 4A*

XTALCLK

MCCLK

POR

SYNWR

LOCK

FILTENB

LOC

50, 51, 52, 53, 55, 56, 57, 58, 59, 60, 65, 66, 67, 68, 70, 71, 72, 73, 74

FIG. 4B

EP 0 355 466 A2

| | |
|---|---|
| *FIG.4A* | *FIG.4B* |

*FIG.4C*